Europäisches Patentamt

(19) European Patent Office

Office européen des brevets

(11) Publication number: **0 028 650**
**B1**

(12) **EUROPEAN PATENT SPECIFICATION**

(45) Date of publication of patent specification: **23.11.83**

(21) Application number: **80901204.0**

(22) Date of filing: **20.05.80**

(86) International application number:
**PCT/US80/00594**

(87) International publication number:
**WO 80/02618 27.11.80 Gazette 80/27**

(51) Int. Cl.³: **G 11 C 19/28,**
**H 01 L 29/78,**
**H 03 H 15/02, H 03 H 19/00**

(54) **APPARATUS FOR SAMPLING, FILTERING AND MULTIPLEXING DATA.**

(30) Priority: **21.05.79 US 40948**

(43) Date of publication of application:
**20.05.81 Bulletin 81/20**

(45) Publication of the grant of the patent:
**23.11.83 Bulletin 83/47**

(84) Designated Contracting States:
**DE FR GB NL**

(56) References cited:
**US - A - 4 124 861**
**US - A - 4 124 862**
**US - A - 4 125 786**
**US - A - 4 126 852**
**US - A - 4 172 983**

(73) Proprietor: **GENERAL ELECTRIC COMPANY**
**1 River Road**
**Schenectady New York 12305 (US)**

(72) Inventor: **QUICK, Marshall Kenneth**
**146 Main Street**
**Whitesboro, NY 13492 (US)**

(74) Representative: **Sanders, Peter Colin Christopher et al,**
**BROOKES & MARTIN High Holborn House 52/54 High Holborn**
**London WC1V 6SE (GB)**

# Apparatus for sampling, filtering and multiplexing data

The present invention relates in general to switched capacitor sampled data filters which provide a high-pass frequency response, and in particular relates to charge transfer apparatus incorporating a plurality of such switched capacitor high-pass filters for sampling, filtering and multiplexing a plurality of data input signals.

The present invention has particular application in infrared signal processing systems. In such systems an array of detectors are provided, for sensing the radiation of a scene to be scanned. The scanning of the scene produces a plurality of signals, one from each of the detectors. Each of the signals is sampled and filtered to remove the DC or background component thereof. Thereafter corresponding samples of each of the signals are multiplexed to provide sequences of sampled signals. These sequences are further processed to provide video signals corresponding to the scene scanned. The present invention is directed to the provision of improvements in apparatus providing these functions.

An object of the present invention as defined in claim 1 is to provide a data sampling, filtering and multiplexing apparatus which has high rejection for background noise components or DC components in the input signals applied thereto, as well as so-called "pattern-noise" signals, and which filters the desired signals in improved manner.

In the subsequent description reference will be made to the following literature:

U.S. Patent Specification No. 4,125,786 MacLennan, and the corresponding published British Patent Application 2,002,960A, published-in-print on 28 February 1979, hereinafter collectively referred to as MacLennan I.

U.S. Patent Specification No. 4,172,983 MacLennan, hereinafter referred to as MacLennan II.

MacLennan I describes utilization of apparatus of the general class to which the apparatus of this invention belongs. However MacLennan I is directed to the demultiplexing of already sampled and multiplexed data. The present invention, is directed to the sampling and multiplexing of input data signals. The apparatus of the present invention is similar to that of MacLennan II up to a certain point, and to this extent it comprises:

A semiconductor structure, which is formed of: (1) a substrate of semiconductor material of one conductivity type having a major surface. (2) a charge transfer shift register which includes n stages plus a charge input stage and a charge output stage, each stage having a respective storage electrode which provides a charge storage region adjacent the major surface; (3) n capacitors. (4) n regions of opposite conductivity type each situated adjacent a respective storage region and connected to a first electrode of a respective capacitor.

The apparatus common to MacLennan II and the present invention further includes clocking means which transfer charge from stage to stage of the shift register, an initial charge input circuit and an ultimate charge output circuit, and gating means which establishes a charge transfer channel between each storage region and its respective region of opposite conductivity type.

At this point the present invention departs from MacLennan II. The present invention provides for parallel sampling of plural data input signals, and accelerates the sampling and multiplexing operations in other respects. Since parallel operation tends to render the apparatus more sensitive to noise, the present invention provides measures which result in appreciable noise reduction and improved filtering.

Accordingly the apparatus of the invention further comprises n signal input terminals, each connected to the second electrode of a respective capacitor, and to which are applied on an essentially continuous basis, n analog input signals respectively. For the purpose of sampling, there is introduced serially for storage into the respective n stages, the same number n of packets of fixed quantities of charge, to form an initial first sequence of n such stored packets. The gating means is actuated to alter simultaneously the charge-contents of the n packets, each content in accordance with its respective analog input signal, thereby forming an initial second sequence of charge packets. The formation of first and second sequences is repetitive. The charge output circuit senses in succession the charge packets of each said second sequence.

Moreover, in the interest of accelerating the sampling and multiplexing process, a new first sequence is formed even while the thereto previous second sequence is read out.

The invention together with further objects and advantages thereof may best be understood by reference to the following description taken in connection with the accompanying drawings wherein:

Figure 1 shows a schematic diagram of a switched capacitor high-pass filter.

Figure 2 illustrates apparatus in accordance with an embodiment of the present invention, partly as structural plan view, and partly as electrical block diagram.

Figure 3 is a sectional view of the embodiment of Figure 2 taken along section lines 3—3 thereof.

Figures 4A to 4E show diagrams of voltage waveforms useful in explaining the operation of the apparatus of the present invention.

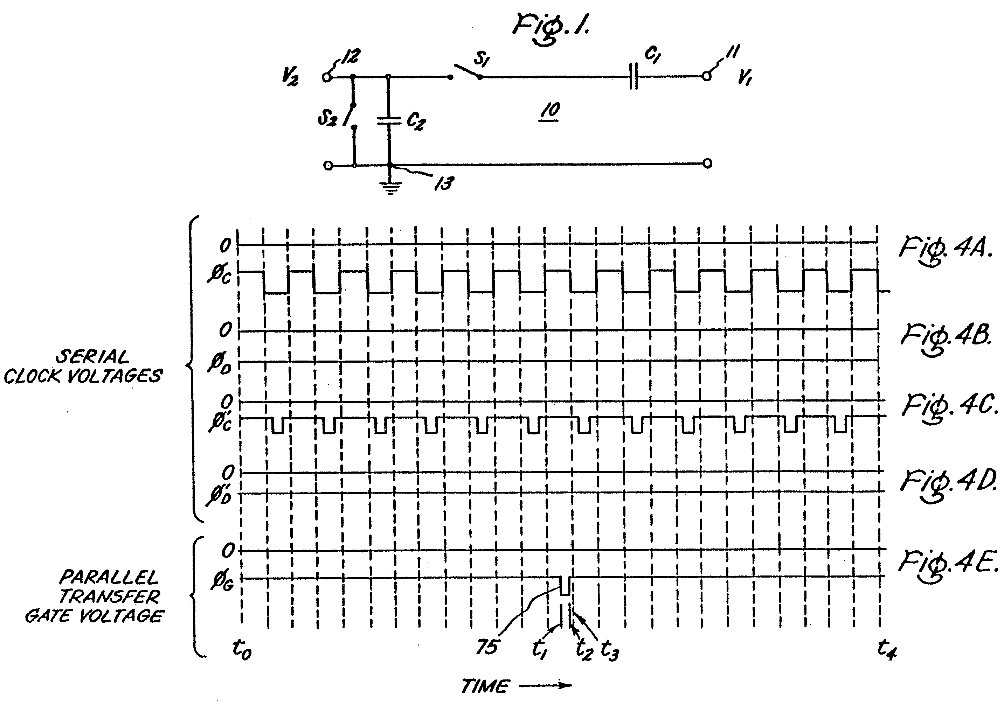

Reference is now made to Figure 1 which shows a conventional switched capacitor high pass filter. The circuit comprises two capacitors $C_1$ and $C_2$ and two switches $S_1$ and $S_2$. The capacitor $C_1$, switch $S_1$ and capacitor $C_2$ are connected in series in the order named between an input terminal 11 and ground terminal 13. Switch $S_2$ is connected across capacitor $C_2$. An output terminal 12 is connected to the ungrounded electrode of capacitor $C_2$. The switches $S_1$ and $S_2$ are operated synchronously but in a manner such that both switches are not closed at the same time. An input signal $V_1$ to be filtered is applied between terminal 11 and ground. A filtered output signal is obtained between output terminal 12 and ground.

In operation, the capacitor $C_2$ is precharged to a zero level by closing switch $S_2$. On the next part of the cycle, switch $S_1$ is closed and couples the input signal $V_1$ through $C_1$ to the output terminal 12 where it appears as $V_2$. The charge $q_1$ stored on $C_1$ prior to closing $S_1$ is determined by the values of $V_1$ and $V_2$ at the end of the last $[(i-1)^{th}]$ switching cycle, and is given by the equation:

$$q_1(i-1)=[V_2(i-1)-V_1(i-1)]C_1 \quad (1)$$

The new charge on $C_1$ becomes $[V_2(i)-V_1(i)]C_1$ and the charge on $C_2$ becomes $V_2(i)C_2$. Since the action of closing switch $S_1$ can only redistribute charge, the total charge before and after switch $S_1$ is closed must be equal, i.e.

$$[V_2(i-1)-V_1(i-1)]C_1=[V_2(i)-V_1(i)]C_1+V_2(i)C_2,$$

or

$$V_1(i)-V_1(i-1)-V_2(i)[1+\frac{C_2}{C_1}]-V_2(i-1)$$

$$(2)$$

Taking the z-transform of equation 2 and solving for the transfer function yields:

$$H(z)=V_2(z)/V_1(z)=a\frac{z-1}{z-a}, \quad (3)$$

where

$$a=\frac{C_1}{C_1+C_2}$$

It is evident from equation (3) the filter has a high pass characteristic as there is a zero at $z=1$ and a pole at

$$z=\frac{C_1}{C_1+C_2}.$$

The frequency response of the filter is obtained by the substitution of $e^{+j\omega T}$ for z in equation 3:

$$|H(j\omega)|=a\sqrt{\frac{2(1-\cos\omega T)}{1-2a\cos\omega T+a^2}}, \quad (4)$$

where $\omega$ represents the frequency of the input signal and T is the period of the switching cycle.

The frequency response at $\omega=0$ is 0 and at the Nyquist rate, $\omega=\pi/T$, the response is given by the following:

$$|H(j\omega)|=\frac{2a}{1+a}=\frac{2C_1}{2C_1+C_2}$$

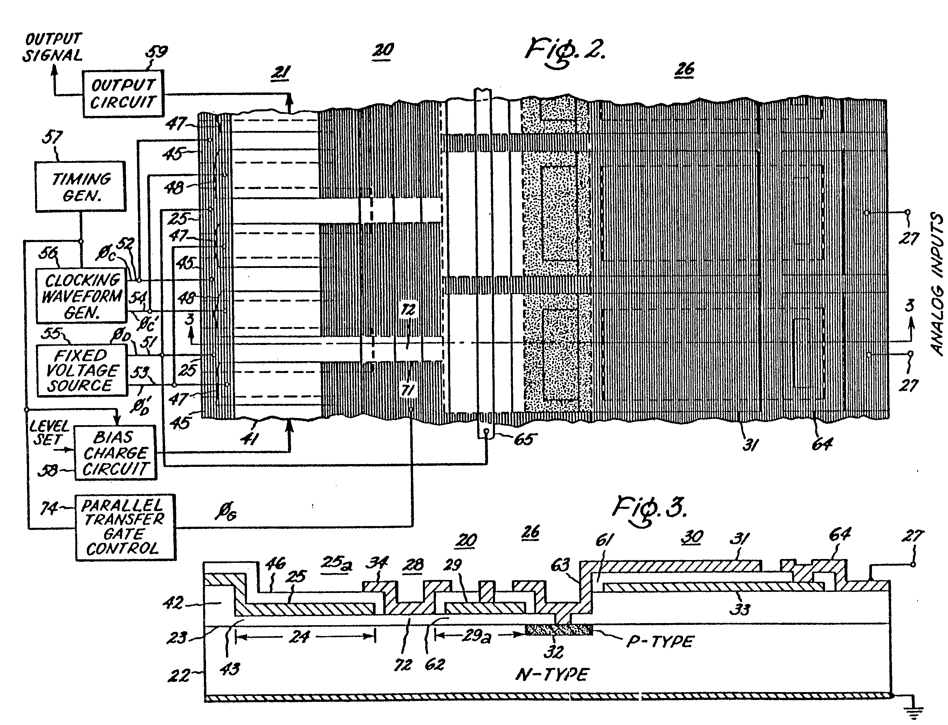

Reference is now made to Figures 2 and 3 which show apparatus 20 in accordance with the present invention in which a plurality of switched capacitor high pass filters such as shown in Figure 1 are provided and in which the outputs thereof are multiplexed. The apparatus includes a charge transfer shift register 21 having n stages. The shift register 21 is formed on a substrate 22 of semiconductor material of one conductivity type having a major surface 23. Each of the stages of the shift register includes a respective first storage region 24 adjacent the major surface 23 and a first storage electrode 25 insulatingly overlying the first storage region. The apparatus 20 also includes a plurality of switched capacitor high-pass filters 26, such as shown in Figure 1, only two of which are shown completely. Each of the filters 26 includes an input terminal 27, a first capacitor 30, a second capacitor 25a and a gating stage 28 corresponding to input terminal 11, capacitor $C_1$, capacitor $C_2$, and switch $S_1$, respectively, of Figure 1. The first capacitor 30 includes a first electrode 31 connected to a region 32 of opposite conductivity type, situated adjacent a respective first storage region 24 of the shift register and a second electrode 33 connected to the input terminal 27. The second capacitor 25a comprises the capacitance of the first storage electrode 25 with respect to the substrate 22 and the depletion capacitance of the storage region 24. The capacitance of the first capacitor 30 is substantially greater than the capacitance of the second capacitor 25a. An auxiliary electrode 29 is provided insulatingly overlying the surface adjacent region of the substrate contiguous the region 32 of opposite conductivity type. The electrode 29 is connected to the potential of the electrode 25 and establishes an inversion layer as conduction channel in the surface adjacent region of the substrate lying thereunder. The gating stage 28 comprises a gating electrode 34 insulatingly overlying the surface adjacent region of the substrate 22 between the first storage region 24 and the surface adjacent region underlying the auxiliary electrode 29 for controlling conduction between the first electrode 31 of the first capacitor and the first storage region 24 underlying electrode 25 of the second capacitor. The provision of such an electrode facilitates the fabrication of the apparatus and, if desired, may be eliminated. In such case the region 32 of opposite conductivity type would be contiguous with the surface adjacent region underlying the gating electrode 34.

The substrate 22 may be constituted of silicon semiconductor material of N-type conductivity and of suitable resistivity, for example, 4 ohm centimeters. The substrate is provided with a channel portion 41 over which the shift register 21 is formed. Overlying major surface 23 of the substrate 22 is a thick insulating member 42 of silicon dioxide having a thin portion 43 therein lying in registry with the channel portion 41. In Figure 2 the thick portions of the insulator 42 are indicated by shading. A plurality of first storage electrodes 25 are provided on the insulating member 42 overlying the thin portion 43. Each of the first storage electrodes is of uniform length in the direction of the length dimension of the channel portion 41, i.e. in the direction of charge transfer. Each of the first storage electrodes extends across both the thin insulating portion 43 and the bordering thick insulating portions of the insulating member 42. A plurality of second storage electrodes 45 is provided on the insulating member 42 overlying the thin portion 43. Each of the electrodes 45 is of uniform length in the direction of the length dimension of the channel portion 41 and equal to the uniform length of the first storage electrodes 25. Each of the electrodes 45 extends across both the thin insulating portion 43 and the bordering thick insulating portions of insulating member 42. An insulating layer 46 is provided over the electrodes 25 and 45. A plurality of first transfer electrodes 47 are provided over the insulating layer 46. Each of the first transfer electrodes 47 is insulatingly spaced between a respective second storage electrode 45 and an adjacent succeeding first storage electrode 25 and overlying these electrodes. A plurality of second transfer electrodes 48 are provided over the insulating layer 46. Each of the second transfer electrodes 48 is insulatingly spaced between a respective first storage electrode 25 and an adjacent succeeding second storage electrode 45 and overlying these electrodes. Each of the transfer electrodes 47 and 48 is of substantially uniform extent in the direction of the length of the channel portion 41 and extends over the thin insulating portion 41 of the insulating member 42 as well as the bordering thick insulating portions thereof.

All of the first storage electrodes 25 of the shift register 21 are connected to a line 51 to which a $\phi_D$ voltage is supplied from a fixed voltage source 55. All of the second storage electrodes 45 of the shift register 21 are connected to line 52 to which a $\phi_C$ voltage is supplied from a clocking waveform generator 56. The clocking waveform generator 56 is under the control of the timing generator 57. All of the first transfer electrodes 47 of the shift register 21 are connected to a $\phi_D'$ line 53 to which a $\phi_D'$ voltage is supplied from fixed voltage source 55. All of the second transfer electrodes 48 of the shift register 21 are connected to a $\phi_C'$ line 54 to which a $\phi_C'$ voltage is applied from a clocking waveform generator 56. The $\phi_C$, $\phi_D$, $\phi_C'$ and the $\phi_D'$ voltage waveforms are shown in Figs. 4A through 4D, respectively.

The filter stages 26 are formed on the semiconductor substrate 22. A plurality of second electrodes 33 of first capacitors 30 is provided, each overlying a portion of thick insulator 42. A thin insulating layer 61 is provided over electrodes 33. A plurality of first electrodes 31 of capacitors 30 is provided, each overlying thin insulating layer 61. A plurality of third or auxiliary electrodes 29 is provided, each overlying thin insulating layer 62 which in turn overlies a respective surface adjacent portion 29a of the substrate and forming a third capacitor therewith. A plurality of regions 32 of opposite conductivity type indicated by stiple shading in Figure 2 is provided in the substrate adjacent the major surface 23 thereof, each contiguous with a respective surface adjacent portion 29a. Each region 32 of opposite conductivity type is connected to a respective first electrode 31 by a respective conductor 63. A plurality conductive connections 64 are provided, each between a respective second electrode 33 of capacitor 30 and a respective input terminal 27. A conductive connection 65 is provided to all of the third electrodes 29 which is connected to the $\phi_D$ line 51 of the fixed voltage source 55. Thus, with the application of the indicated potential to a third electrode 29, a third capacitance is provided between the third electrode and the substrate. The $\phi_D$ electrodes 25 of the shift register 21 form second capacitors with the surface adjacent regions of the substrate lying thereunder.

A plurality of thin recesses 71 are provided in the thick insulating member 42 underlying which are thin insulating portions 72, each connecting a respective part of the thin insulating portion 43 with a respective part of the thin insulation portion 62. The first or $\phi_D$ electrodes 25 of the shift register 21 extend into the recesses 71 and each overlie a first part of a respective thin insulating portion 72. A parallel transfer gate or line 34 is provided on the insulating portion 42 between the thin insulating portions 43 and 62 overlying the recesses 71 between the $\phi_D$ electrodes 25 and the third electrodes 29. The parallel transfer gate 34 is connected to a parallel transfer gate control 74 which provides a parallel transfer gate voltage $\phi_G$, as shown in Figure 4E. The parallel transfer gate control 74 is synchronized with the timing generator 57. When a suitable gate potential is applied to the gate electrode 34 a conductive channel is formed in the underlying surface adjacent region of the substrate 22 which enables transfer of charge from the storage regions 24 underlying the $\phi_D$ electrodes of the shift register 21 to the first storage regions 29a underlying the third electrodes 29 of the filter stages and to the first electrode 31 of first capacitor 30.

Each stage of the shift register 21 includes a $\phi_D$ storage region underlying a $\phi_D$ electrode 25 and a $\phi_C$ storage region underlying a $\phi_C$ electrode 45. The $\phi_D$ voltage applied to the $\phi_D$ electrode is fixed. The $\phi_C$ voltage applied to the $\phi_C$ electrode cycles between a high level and a low level above and below the $\phi_D$ voltage. When the $\phi_C$ voltage is at its high level, charge transfer is enabled from the $\phi_C$ storage region to the $\phi_D$ storage region and conversely when the $\phi_D$ voltage is at its low level, charge transferred from the $\phi_D$ storage region to the $\phi_C$ storage region is enabled. Each stage also includes a $\phi_D{}'$ electrode 47 to which is applied a $\phi_D{}'$ voltage of fixed value which produces a surface potential in the substrate underlying the electrode which is smaller in absolute magnitude than the surface potential underlying a $\phi_D$ electrode. Each stage also includes a $\phi_C{}'$ electrode 48 to which is applied a $\phi_C{}'$ voltage having two levels. At the upper level a surface potential is produced in the substrate underlying the electrode which inhibits the transfer of charge from a $\phi_D$ storage region to a $\phi_C$ storage region. At the lower level a surface potential is produced enabling the transfer charge from a $\phi_D$ storage region to a $\phi_C$ storage region.

Packets of charge of fixed value for insertion into the shift register 21 are generated by a bias charge input circuit 58 under the control of the clocking waveform generator 56 and in response to bias charge setting controls. One input circuit for developing sequence of packets of charge and for inserting the packets into a charge transfer shift register is described in connection with Figs. 2 and 3 of U.S. Patent No. 4,126,852 Baertsch, incorporated herein by reference.

After charge packets have been clocked into the shift register 21 and have been equilibrated and hence modified by the various filter stages 26 of the apparatus in a manner to be explained below, the resultant packets of charge are contained in the storage regions underlying the $\phi_D$ electrodes 25. The resultant packets of charge are then clocked out of the shift register and sensed in an output circuit 59 from which an output signal is obtained. One output circuit suitable for providing an output in accordance with the sequence of packets of charge clocked thereinto is described in connection with Figure 1 of MacLennan I.

The operation of the apparatus of Figures 2 and 3 will now be explained in connection with the waveform diagrams of Figures 4A to 4E. It will be recalled that n is the number of stages of the shift register 21, and also of the filters provided. Furthermore, it is also the number of analog signals to be sampled and multiplexed, each being applied on an essentially continuous basis to a respective input terminal 27. During a first period of time $t_0$ to $t_1$, an initial first sequence of n packets of charge, each including a fixed quantity of charge, are generated and clocked serially into the shift register 21; in consequence, the packets are stored in the respective ones of the n first storage regions or $\phi_D$ storage regions. After charge has thus been transferred into the $\phi_D$ storage regions, during a second time-period $t_1$ to $t_2$—this occurs during the short interval of the $\phi_C$ clock cycle when the $\phi_C$ voltage is high—, a gating pulse 75 (Figure 4E) is provided to the parallel transfer gate 34 enabling the charges underlying the $\phi_D$ electrodes concurrently to flow into the respective surface adjacent portions of the substrate underlying the respective third electrodes 29 and equilibrate therewith as well as with the potential on the respective first electrodes 31 of the respective first capacitors 30. During this second period the charge-contents (fixed quantity) of the n stored packets are simultaneously modified, each charge-content in accordance with its respective analog signal applied to its respective input terminal 27. Thus an initial second sequence of modified packets of charge are contained in the storage regions underlying the $\phi_D$ electrodes of the shift register 21. During a third period of time $t_3$ to $t_4$, subsequent to time $t_2$, the initial second sequence packets of modified charge-content, which are stored in the storage regions underlying the $\phi_D$ electrodes, is clocked out sequentially or serially into the output circuit 59 where these n packets are sensed sequentially so that multiplexed output signals are read out from the circuit 59. During the third period of time while the initial second sequence is clocked out of the shift register 21, a new first sequence of packets of fixed value is clocked serially into the shift register 21 for processing in the same manner as the initial first sequence of packets. Thus, successive first sequences of packets of fixed charge-content are processed into successive second sequences, which are read out. The second sequences of multiplexed samples may be utilized directly to provide a display. Also, corresponding output samples of the successive second sequences may be demultiplexed, if desired, to provide a plurality of demultiplexed or "third" sequences of output samples, each corresponding to a respective one of the n analog input signals. It should be noted that the formation of a second sequence occurs essentially without any interruption in the clocking of charge in the shift register 21; so that the formation of a new first sequence takes place concurrently with the readout of a thereto previous second sequence. Thus, the rate at which an input signal is sampled, is equal to the rate at which the gating pulses 75 are generated. The rate of transfer of charge from stage to stage of the shift register is n times the rate of sampling of an input signal, i.e. n times the rate of generation of the gating pulses 75.

The function of the second switch $S_2$ of Figure 1 is implemented in the apparatus of Figure 2 by the dynamic operation of the shift register 21. The transfer of a fixed packet of charge into a storage region corresponds to a closing and opening of the switch $S_2$ and the actuation of the transfer channel to that storage region by gating voltage applied to the gating electrode 34 corresponds to a closing and opening of switch $S_1$.

The high-pass multiplexed charge transfer apparatus described offers several advantages. A primary advantage is that the zero in the transfer function of each of the filter stages 26 is inherent in the capacitive coupling provided by the first capacitors to the first storage regions of the shift register. Thus, the DC rejection is limited only by the signal dependent leakage currents appearing across the input capacitors 30. The second advantage is that low pattern noise is achieved in this apparatus. The principle source of pattern noise in this apparatus is the non-uniformity in leakage current to the first electrode 31 of capacitor 30. When the apparatus is operated at cryogenic temperatures, this leakage becomes extremely small. The third advantage of the apparatus is that the frequency response of the filter sections is determined only by the clock frequency and by the ratio of the first capacitance 30 and the second capacitance 25a of the stages of the shift registers. Since the ratio of these capacitances is determined by the ratio of two areas, the frequency response may be accurately predicted and controlled.

While in the apparatus described in connection with Figures 2 and 3, third storage electrodes 29 were provided in the gating stages of each of the filter stages in order to facilitate fabrication and to enable each filter stage to be designed with precision particularly with respect to the location of the regions of opposite conductivity type with respect to the gating electrode 34. Such third electrodes 29 could be eliminated, if desired, and each of the regions 32 of opposite conductivity type of each of the filter stages made contiguous with the surface adjacent region underlying each of the gate electrodes 34. In the design shown the third electrodes provide in effect a small third capacitance connected between the first electrode of the first capacitor 30 and the ground or reference terminal of the filter. The third capacitance adds a small capacitance to the capacitance 30 and increases the time constant of the filter stage 26 while decreasing the gain thereof.

While the invention has been described in connection with the apparatus constituted of N-type conductivity substrates, P-type conductivity substrates could as well be used. Of course, in such case the applied potentials would be reversed in polarity.

## Claims

1. Apparatus for sampling, filtering and multiplexing input data signals, comprising a semiconductor structure formed of:

a substrate (22) of semiconductor material of one conductivity type having a major surface (23),

a charge transfer shift register (21) comprised of n stages plus a charge input stage and a charge output stage, each of said stages having a respective storage electrode (25) insulatingly overlying said major surface to provide a respective first charge storage region (24) adjacent said major surface (23),

n capacitors (30), each capacitor including a first electrode and a second electrode (31, 33)

n regions (32) of opposite conductivity type adjacent said major surface, each situated adjacent a respective first storage region (24), the first (31) electrode of each capacitor connected to a respective region of opposite conductivity type, said apparatus further comprising:

clocking means (56) for transferring charge from stage to stage of said shift register,

a charge input circuit (58) for generating and transferring charge into said input stage and a charge output circuit (59) for sensing charge transferred out of said output stage,

gating means (34, 74) for establishing a charge transfer channel between each of said first storage regions (24) and a respective region (32) of opposite conductivity type, characterized by n signal input terminals (27) each connected to the second electrode of a respective one of said capacitors (30),

means for applying on an essentially continuous basis, n analog input signals, each to a respective one of said input terminals (27)

means for introducing sequentially into the respective n stages of the shift register (21) for storage therein, via said input circuit (58) and under control of said clocking means (56), packets of fixed charge-content, thereby to form an initial sequence of such stored packets of fixed charge-content, and for subsequently re-introducing in like manner such n packets of fixed charge-content, to form similar such first sequences,

means for initially actuating said gating means (34, 74) after the n packets of the initial first sequence are stored in the n first storage regions of said shift register (21), for an interval less than the interval of storage therein, whereby to alter the charge-content of each packet then stored, concurrently with the alteration of the charge-content of each other packet then stored, each in accordance with its respective analog input signal applied through its respective capacitor, whereby to form an initial second sequence of packets of modified charge-content, and for subsequently repeatedly re-actuating said gating means in like manner, to form similar such second sequences, said charge output circuit (59) sensing serially the charge-content of each said second sequence.

2. Apparatus as claimed in Claim 1, wherein the formation of a new first sequence takes place substantially concurrently with the sensing of the thereto preceding second sequence.

3. Apparatus as claimed in Claim 1 or 2, in which the rate of transferring charge from stage to stage of said shift register (21) is n times the rate of actuation of said gating means (34, 74).

4. Apparatus as claimed in Claim 1 or 2, in which said n capacitors are situated on said substrate (22).

5. Apparatus as claimed in Claim 1 or 2, in which the capacitance of each of said capacitors (30) is substantially greater than the capacitance of a respective storage electrode (25) with respect to said substrate (22).

6. Apparatus as claimed in Claim 1 or 2, in which a plurality of auxiliary electrodes (29) are provided, each insulatingly overlying a respective surface adjacent conduction channel region of said substrate (22), each of said conduction channel regions being contiguous to a respective charge transfer channel established by said gating means (34, 74) and a respective region (32) of opposite conductivity type, and in which means are provided for establishing conduction in each said conduction channel region.

**Revendications**

1. Appareil pour échantillonner, filtrer et multiplexer des signaux de données d'entrée, comprenant une structure semiconductrice formée par:

un substrat (22) en matière semiconductrice d'un premier type de conductivité ayant une surface principale (23),
un registre à décalage à transfert de charge (21) comprenant n étages plus un étage d'entrée de charge et un étage de sortie de charge, chacun de ces étages comportant une électrode de stockage respective (25) recouvrant la surface principale, en étant isolée de cette dernière, pour définir une première région de stockage de charge respective (24) adjacente à la surface principale (23),
n condensateurs (30), chaque condensateur comprenant une première électrode et une seconde électrode (31, 33),
n régions (32) du type de conductivité opposé, adjacentes à la surface principale, chacune d'elles étant adjacente à une première région de stockage respective (24), tandis que le première électrode (31) de chaque condensateur est connectée à une région respective du type de conductivité opposé, cet appareil comprenant en outre:

des moyens de génération de signaux d'horloge (56) destinés à transférer une charge d'étage en étage du registre à décalage,
un circuit d'entrée de charge (58) destiné à générer une charge et à la transférer dans l'étage d'entrée, et un circuit de sortie de charge (59) destiné à détecter une charge transférée hors de l'étage de sortie,
des moyens de transmission sélective (34, 74) destinés à établir un canal de transfert de charge entre chacune des premières régions de stockage (24) et une région respective (32) du type de conductivité opposé;
caractérisé par n bornes d'entrée de signaux (27), chacune d'elles étant connectée à la seconde électrode de l'un respectif des condensateurs (30),
des moyens destinés à appliquer d'une manière fondamentalement continue n signaux d'entrée analogiques, chacun d'eux étant appliqué à l'une respective des bornes d'entrée (27),
des moyens destinés à introduire séquentiellement dans les n étages respectifs du registre à décalage (21), pour le stockage dans ces derniers, par l'intermédiaire du circuit d'entrée (58) et sous la commande des moyens de génération de signaux d'horloge (56), des paquets contenant une charge fixe, pour former ainsi une séquence initiale de tels paquets stockés contenant une charge fixe, et pour réintroduire par la suite d'une manière semblable n tels paquets contenant une charge fixe, pour former de telles premières séquences similaires,
des moyens pour actionner intialement les moyens de transmission sélective (34, 74) après que les n paquets de la première séquence initiale ont été stockés dans les n premières régions de stockage du registre à décalage (21), pendant un intervalle inférieur à l'intervalle de stockage dans ces régions, de façon à modifier la charge contenue dans chaque paquet stocké au moment considéré, simultanément à la modification de la charge contenue dans chaque autre paquet stocké au moment considéré, en procédant pour chacun conformément au signal d'entrée analogique respectif appliqué par l'intermédiaire du condensateur respectif, pour former ainsi une seconde séquence initiale de paquets contenant une charge modifiée, et pour actionner à nouveau par la suite de façon répétée les moyens de transmission sélective, d'une manière semblable, pour former de telles secondes séquences similaires,
le circuit de sortie de charge (59) détectant en série la charge contenue dans chaque seconde séquence.

2. Appareil selon la revendication 1, dans lequel la formation d'une nouvelle première séquence a lieu de façon pratiquement simultanée à la détection de la seconde séquence qui la précède.

3. Appareil selon la revendication 1 ou 2, dans lequel la cadence de transfert de charge d'étage en étage du registre à décalage (21) est n fois la cadence à laquelle les moyens de transmission sélective (34, 74) sont actionnés.

4. Appareil selon la revendication 1 ou 2, dans lequel n condensateurs sont situés sur le substrat (22).

5. Appareil selon la revendication 1 ou 2, dans lequel la capacité de chacun des condensateurs (30) est notablement supérieure à la capacité d'une électrode de stockage respective (25) par rapport au substrat (22).

6. Appareil selon la revendication 1 ou 2, dans lequel il existe plusieurs électrodes auxiliaires (29), chacune d'elle recouvrant, avec interposition d'un isolant, une région de canal de conduction respective du substrat (22), adjacente à la surface, chacune des régions de canal de conduction étant contiguë à une canal de transfert de charge respectif établi par les moyens de transmission sélective (34, 74), et à une région respective (32) du type de conductivité opposé, et dans lequel il existe des moyens destinés à établir la conduction dans chacune région de canal de conduction.

## Patentansprüche

1. Apparat zum Bilden von Momentwerten, Filtern und Bündeln von Eingangsdatensignalen mit einer Halbleiterstruktur, die aus

einem Substrat aus einem Halbleitermaterial des einen Leitfähigkeitstyps mit einer Hauptoberfläche (23),

einem Ladungsübertragungs-Schieberegister (21) aus n Stufen plus einer Ladungseingangsstufe und einer Ladungsausgangsstufe, die jeweils eine entsprechende Speicherelektrode (25) aufweisen, die isolierend über der Hauptoberfläche liegt zur Bildung eines entsprechenden ersten Ladungsspeicherbereiches (24) neben der Hauptoberfläche (23),

n Kondensatoren (30), die jeweils eine erste Elektrode und eine zweite Elektrode (31, 33) aufweisen,

n Bereichen (32) des entgegengesetzten Leitfähigkeitstyps neben der Hauptoberfläche gebildet ist, die jeweils neben einem entsprechenden ersten Speicherbereich (24) angeordnet sind, wobei die erste Elektrode (31) jedes Kondensators mit einem entsprechenden Bereich des entgegengesetzten Leitfähigkeitstyps verbunden ist, und ferner mit:

einer Takteinrichtung (56) zur Ladungsübertragung von Stufe zu Stufe des Schieberegisters,

einer Ladungseingangsschaltung (58) zum Erzeugen und Übertragen von Ladung in die Eingangsstufe und einer Ladungsausgangsstufe (59) zum Abtasten von aus der Ausgangsstufe übertragener Ladung,

einer Steuereinrichtung (34, 74) zum Bilden eines Ladungsübertragungskanals zwischen jedem der ersten Speicherbereiche (24) und einem entsprechenden Bereich (32) des entgegengesetzten Leitfähigkeitstyps, gekennzeichnet durch n Signaleingangsanschlüsse (27), die jeweils mit der zweiten Elektrode eines entsprechenden Kondensators (30) verbunden sind,

Mittel zum Anlegen auf im wesentlichen kontinuierlicher Basis von n analogen Eingangssignalen an jeweils einen entsprechenden der Eingangsanschlüsse (27),

Mittel zum sequentiellen Einführen in die entsprechenden n Stufen des Schieberegisters (21) für eine Speicherung, über die Eingangsschaltung (58) und unter Steuerung der Takteinrichtung (56), von Paketen mit festem Ladungsgehalt zur Bildung einer Anfangsfolge derartiger gespeicherter Pakete mit festem Ladungsgehalt und zum anschließenden Wiedereinführen in gleicher Weise dieser n Pakete mit festem Ladungsgehalt zur Bildung ähnlicher erster Folgen,

Mittel zum ersten Betätigen der Steuereinrichtung (34, 74), nachdem die n Pakete der ersten Anfangsfolge in den n ersten Speicherbereichen des Schieberegisters (21) gespeichert sind, für ein Intervall, das kleiner als das Intervall der Speicherung darin ist, zum Ändern des Ladungsgehaltes von jedem dann gespeicherten Paket gleichzeitig mit der Änderung des Ladungsgehaltes von jedem anderen dann gespeicherten Paket jeweils gemäß seinem entsprechenden analogen Eingangssignal, das über seinen entsprechenden Kondensator angelegt ist, um dadurch eine zweite Anfangsfolge von Paketen mit geändertem Ladungsgehalt zu bilden und um anschließend die Steuereinrichtung in gleicher Weise wiederholt erneut zu betätigen zur Bildung ähnlicher zweiter derartiger Folgen,

die Ladungsausgangsschaltung (59) tastet der Reihe nach den Ladungsgehalt von jeder zweiten Folge ab.

2. Apparat nach Anspruch 1, dadurch gekennzeichnet, daß die Bildung einer neuen ersten Folge im wesentlichen gleichzeitig mit dem Abtasten der dieser vorangehenden zweiten Folge stattfindet.

3. Apparat nach Anspruch 1 oder 2, dadurch gekennzeichnet, daß die Geschwindigkeit der Übertragung von Ladung von Stufe zu Stufe des Schieberegisters (21) die n-fache Geschwindigkeit der Betätigung der Steuereinrichtung (34, 74) beträgt.

4. Apparat nach Anspruch 1 oder 2, dadurch gekennzeichnet, daß auf dem Substrat (23) n Kondensatoren angeordnet sind.

5. Apparat nach Anspruch 1 oder 2, dadurch gekennzeichnet, daß die Kapazität von jedem Kondensator (30) wesentlich größer ist als die Kapazität von einer entsprechenden Speicherelektrode (25) in bezug auf das Substrat (23).

6. Apparat nach Anspruch 1 oder 2, dadurch gekennzeichnet, daß mehrere Hilfselektroden (29) vorgesehen sind, die jeweils isolierend über einem entsprechenden, der Oberfläche benachbarten Leitfähigkeitskanalbereich des Substrates (23) liegen, wobei jeder Leitfähigkeitskanalbereich mit einem entsprechenden Ladungsübertragungsbereich zusammenhängt, der durch die Steuereinrichtung (34, 74) und einen entsprechenden Bereich (32) des entgegengesetzten Leitfähigkeitstyps gebildet ist, und daß Mittel vorgesehen sind zur Ausbildung von Leitfähigkeit in jedem Leitfähigkeitskanalbereich.

Fig. 1.

Fig. 4A.

Fig. 4B.

Fig. 4C.

Fig. 4D.

Fig. 4E.

SERIAL CLOCK VOLTAGES

PARALLEL TRANSFER GATE VOLTAGE

TIME →

Fig. 2.

OUTPUT SIGNAL

OUTPUT CIRCUIT  59

TIMING GEN.  57

CLOCKING WAVEFORM GEN.  56

FIXED VOLTAGE SOURCE  55

LEVEL SET

BIAS CHARGE CIRCUIT  58

PARALLEL TRANSFER GATE CONTROL  74

$\phi_C$  52
$\phi_C'$  54
$\phi_D$
$\phi_D'$  53
$\phi_G$

21  20  26

47  45  48  25  47  45  48  25  47  45

41  T2  71  65  31  64

27  ANALOG INPUTS  27  3

0028 650

2

Fig. 3.

46  25a  34  28  29  20  26  61  30  31  64  27
25  63
42
23  24  29a  32  P-TYPE
22  43  72  62  33  N-TYPE